# EUROPEAN PATENT APPLICATION

(11) **EP 4 693 817 A1**
(43) Date of publication of application: **11.02.2026**
(21) Application number: 25170704.8
(22) Date of filing: 15.04.2025
(51) Int. Cl.: H02J 50/00

(54) **A SMART POWER SOLUTION FOR OPENTHERM MASTER DEVICES**

(30) Priority: 06.08.2024 CN 202411075454
(71) Applicant: Siemens Schweiz AG, 8047 Zürich (CH)
(72) Inventor: Liu, Yue, Beijing 100028 (CN); Song, Jun, BSCE, Bei Jing 100094 (CN); Wang, Jin Feng, Xibeiwang, Haidian, Beijing City 100094 (CN)
(74) Representative: Siemens Patent Attorneys

(57) **Abstract**

OpenTherm protocol-based power harvesting apparatus, method, system, medium and product. Embodiments of the present invention disclose an OpenTherm (OT) protocol-based power harvesting apparatus, method, system, medium, and product. The apparatus comprises: a linear voltage regulator configured to provide, based on an OT protocol bus in a low-power mode, a first output voltage suitable for starting a controller comprised in an electrical load module of a thermostat; a variable voltage module configured to adjust a voltage drop of the variable voltage module based on a voltage control command issued by the controller after startup, the voltage drop representing an instruction, to be detected by a boiler, instructing the OT protocol bus to enter a high-power mode; an energy storage module configured to harvest and store electrical energy from the OT protocol bus during a non-communication period in the high-power mode.

## Description

### Technical Field

The present invention relates to the field of temperature control technologies, and in particular to an OpenTherm (OT) protocol-based power harvesting apparatus, method, system, medium, and product.

### Background

The OT protocol is a commonly used protocol for communication between a thermostat and a boiler (e.g., a wall-mounted boiler). According to the OT protocol, the thermostat can communicate with the boiler to control turn-on/off of the boiler and adjust the temperature of the boiler.

The boiler, as a current source, can supply electrical energy to the thermostat connected via the OT protocol. Currently, an increasing number of thermostats are required to provide functionalities such as wireless connectivity (e.g., home IoT communication protocol technologies like Thread or ZigBee) and backlight display. These functionalities necessitate a power supply with higher power capacity.

### Summary of the Invention

Embodiments of the present invention propose an OT protocol-based power harvesting apparatus, method, system, medium, and product.

An OT protocol-based power harvesting apparatus, including: a linear voltage regulator configured to provide, based on an OT protocol bus in a low-power mode, a first output voltage suitable for starting a controller comprised in an electrical load module of a thermostat;
a variable voltage module configured to adjust a voltage drop of the variable voltage module based on a voltage control command issued by the controller after startup, the voltage drop representing an instruction, to be detected by a boiler, instructing the OT protocol bus to enter a high-power mode; an energy storage module coupled to the variable voltage module and configured to harvest and store electrical energy from the OT protocol bus during a non-communication period in the high-power mode; and
a DC-DC converter coupled to the energy storage module and configured to convert a voltage of the stored electrical energy in the energy storage module into a second output voltage suitable for supplying power to the electrical load module of the thermostat.

It is envisaged that the non-communication period is a silent period. It is also envisaged that the non-communication period in the high-power mode is a silent period in the high-power mode.

It can be seen that there is no need to provide a battery for the thermostat. The OT protocol bus in the high-power mode can directly provide electrical energy for the thermostat, thereby saving battery costs and reducing maintenance difficulty. Moreover, compared to the existing processing mechanism that utilizes a linear voltage regulator to supply power to the thermostat, using a DC-DC converter to convert electrical energy of an energy storage module into a second output voltage suitable for supplying power to an electrical load module can provide a greater output power, thereby satisfying specific power requirements of the thermostat (e.g., functionalities such as wireless connectivity and backlight display).

In an embodiment, the apparatus comprises:
a polarity orientation module coupled between the variable voltage module and the OT protocol bus and configured to perform polarity orientation on a current input from the OT protocol bus to the variable voltage module.

Therefore, the polarity orientation functionality of the OT protocol bus can be implemented through the polarity orientation module.

In an embodiment, the polarity orientation module comprises a bridge rectifier circuit.

Therefore, based on the bridge rectifier circuit, polarity orientation can be easily achieved.

In an embodiment, the variable voltage module comprises a voltage regulator diode and a first switch coupled in parallel with the voltage regulator diode, where the first switch is controlled by the controller.

Therefore, based on the controlled first switch and the voltage regulator diode, a variable voltage module can be conveniently implemented.

In an embodiment, the apparatus comprises:
a current limiting module coupled between the energy storage module and the variable voltage module and configured to limit current flowing into the energy storage module to not exceed a predetermined current limit threshold.

It can be seen that by limiting the current flowing into the energy storage module, the normal operation of the linear voltage regulator and the variable voltage module can be guaranteed.

In an embodiment, the current limit threshold is less than or equal to 15 milliamperes.

In an embodiment, the apparatus comprises:
a resistor coupled between the polarity orientation module and
the linear voltage regulator; and
a comparator, where
a first input terminal of the comparator is coupled to an output terminal of the linear voltage regulator, a second input terminal of the comparator is coupled to a coupling point between the resistor and the polarity orientation module, and an output terminal of the comparator is coupled to the controller; and
the comparator is configured to compare an input current at the first input terminal with an input current at the second input terminal, and output, via the output terminal of the comparator, a logic voltage signal determined based on a comparison result; and
the controller configured to, when the logic voltage signal matches a signal pattern of a response message sent by the boiler to the thermostat, generate a state indication representing reception of the response message.

Therefore, by detecting the current change on the OT bus, the controller can conveniently receive the response message sent by the boiler to the thermostat.

In an embodiment, the apparatus comprises:
a second switch coupled between the variable voltage module and the current limiting module;
a third switch coupled between the DC-DC converter and the electrical load module; and
a fourth switch coupled between the linear voltage regulator and the electrical load module,
where the second switch, the third switch, and the fourth switch are separately controlled by the controller.

Therefore, through multiple controlled switches, the control methods can be diversified.

In an embodiment, the electrical load module comprises at least one of the following:
the controller; a wireless connection module; and a backlight apparatus.

It can be seen that there are many types of electrical load modules that can provide additional functions for the thermostat.

An OT protocol-based thermostat, including:
a controller;
a wireless connection module;
a backlight apparatus; and
an OT protocol-based power harvesting apparatus as described above, which is configured to supply power to the controller, the wireless connection module, and the backlight apparatus.

An OT protocol-based system, including:
a boiler; and
a thermostat, the thermostat including the OT protocol-based power harvesting apparatus as described in any of the above.

An OT protocol-based thermostat power supply method, including: providing, based on an OT protocol bus in a low-power mode, a first output voltage suitable for starting a controller comprised in an electrical load module of a thermostat; issuing, based on a voltage control command issued by the controller after startup, an instruction instructing the OT protocol bus to enter a high-power mode;
after the OT protocol bus enters the high-power mode, harvesting and storing electrical energy from the OT protocol bus during a non-communication period in the high-power mode; and
converting a voltage of the stored electrical energy into a second output voltage suitable for supplying power to the electrical load module of the thermostat.

It can be seen that there is no need to provide a battery for the thermostat. The OT protocol bus in the high-power mode can directly provide electrical energy for the thermostat, thereby saving battery costs and reducing maintenance difficulty. Moreover, compared to an existing processing mechanism that utilizes a linear voltage regulator to supply power to the electrical load module, using a DC-DC converter to convert electrical energy of an energy storage module into a second output voltage suitable for supplying power to an electrical module can provide a greater output power, thereby satisfying specific power requirements of the thermostat (e.g., functionalities such as wireless connectivity and backlight display).

In an embodiment, the method comprises:
after the OpenTherm protocol bus enters the high-power mode, determining the non-communication period in the high-power mode when the controller is determined to be not initiating communication with the boiler and the controller determines that a logic voltage signal does not match a signal pattern of a response message sent by the boiler to the thermostat, where the logic voltage signal is determined based on a current of the OT protocol bus.

Therefore, the embodiments of the present invention can accurately and conveniently determine the non-communication period of the OT protocol bus.

In an embodiment, the harvesting and storing electrical energy from the OT protocol bus during a non-communication period in the high-power mode comprises:
limiting an energy storage current to not exceed a predetermined current limit threshold in a process of harvesting and storing electrical energy from the OT protocol bus during the non-communication period in the high-power mode.

In an embodiment, the converting a voltage of the stored electrical energy into a second output voltage suitable for supplying power to the electrical load module of the thermostat comprises:
converting the voltage of the stored electrical energy to the second output voltage suitable for supplying power to the electrical load module of the thermostat when a duration for harvesting and storing electrical energy from the OT protocol bus during the non-communication period in the high-power mode reaches a predetermined time threshold; or
converting the voltage of the stored electrical energy to the second output voltage suitable for supplying power to the electrical load module of the thermostat when the voltage of the stored electrical energy reaches a predetermined voltage threshold.

It can be seen that an appropriate timing for supplying power to the electrical load module can be determined based on multiple methods.

An electronic device, including:
a processor; and
a memory configured to store executable instructions of the processor, where
the processor is configured to read the executable instructions from the memory and execute the executable instructions to implement the OT protocol-based thermostat power supply method as described in any of the above.

A computer-readable storage medium having computer instructions stored thereon, where the computer instructions, when executed by a processor, implement the OT protocol-based thermostat power supply method as described in any of the above.

A computer program product including a computer program, where the computer program, when executed by a processor, implements the OT protocol-based thermostat power supply method as described in any of the above.

### Brief Description of the Drawings

Preferred embodiments of the present invention will be described in detail below with reference to the accompanying drawings to enable those of ordinary skill in the art to more clearly comprehend the aforementioned and other features and advantages of the present invention. In the drawings:
FIG. 1 is an exemplary schematic diagram illustrating coupling between a boiler and a thermostat via the OT protocol.
FIG. 2 is an exemplary structural diagram of an OT protocol-based power harvesting apparatus according to an embodiment of the present invention.
FIG. 3 is a flowchart of an OT protocol-based thermostat power supply method according to an embodiment of the present invention.
FIG. 4 is an exemplary circuit structure diagram of an OT protocol-based power harvesting apparatus according to an embodiment of the present invention.
FIG. 5 is an exemplary schematic diagram of a controller in a thermostat according to an embodiment of the present invention.
FIG. 6 is a schematic diagram illustrating data transmission and switch states according to an embodiment of the present invention.
FIG. 7 is an exemplary flowchart of an OT protocol-based thermostat power supply method according to an embodiment of the present invention.
FIG. 8 is an exemplary structural diagram of an electronic device according to an embodiment of the present invention.

In the accompanying drawings, the reference numerals are as follows:

| Reference Numeral | Description |
|---|---|
| 30 | Boiler |
| 31 | Power supply |
| 40 | Thermostat |
| 100 | OT protocol-based power harvesting apparatus |
| 10 | Polarity orientation module |
| 11 | Linear voltage regulator |
| 12 | Variable voltage module |
| 13 | Energy storage module |
| 14 | DC-DC converter |
| 15 | Current limiting module |
| 16 | Resistor |
| 17 | Comparator |
| 18 | Electrical load module of thermostat |
| 19 | Controller |
| 20 | Wireless connection module |
| 21 | Backlight apparatus |
| k1 | First switch |
| k2 | Second switch |
| k3 | Third switch |
| k4 | Fourth switch |
| 50 | Data transmission waveform of thermostat |
| 51 | First data transmission period |
| 60 | Data transmission waveform of boiler |
| 61 | Second data transmission period |
| 700 - 716 | Steps |
| 800 | Electronic device |
| 801 | Processor |
| 802 | Memory |

### DETAILED DESCRIPTION

To clarify the objectives, technical solutions, and advantages of the present invention, example embodiments are provided below for further detailed description. In this patent application, nouns and pronouns referring to persons shall not be limited to specific genders.

For conciseness and clarity in description, the following describes several representative embodiments to elaborate the solutions of the present invention. Numerous details in the embodiments are provided solely to facilitate understanding of the solutions of the present invention. However, it is evident that the implementation of the technical solutions of the present invention is not limited to these details. To avoid unnecessarily obscuring the solutions of the present invention, some embodiments are not exhaustively described but presented in skeletal form. Hereinafter, "comprising/including" means "comprising/including but not limited to", and "according to..." means "at least according to..., but not limited solely thereto". Due to the linguistic conventions of the Chinese language, when the quantity of a component is not specifically indicated in the following text, it indicates that the component can be either one or multiple, or may be understood as at least one.

The OT protocol is a communication protocol between a boiler and a thermostat (e.g., a room temperature controller), which is not limited by the control systems of manufacturers.

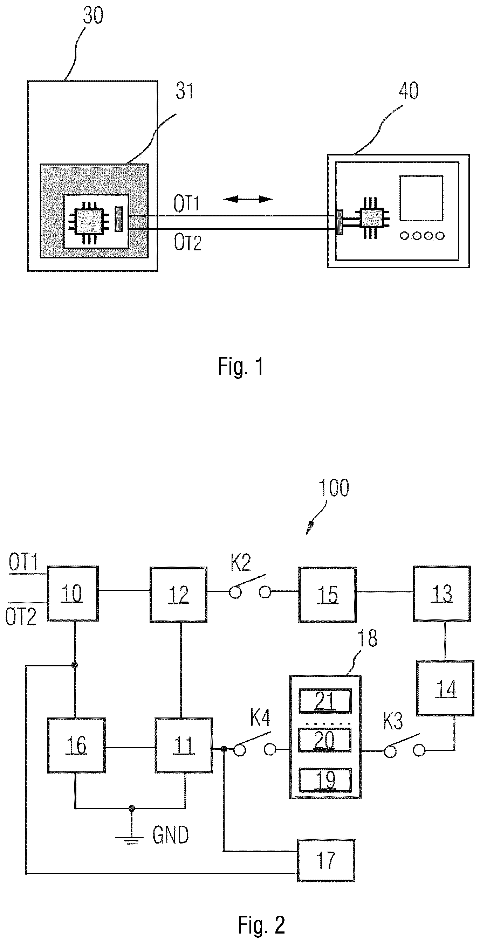

FIG. 1 is an exemplary schematic diagram illustrating coupling between a boiler and a thermostat via the OT protocol. The boiler 30 comprises a power supply 31, where the power supply 31 is coupled to the thermostat 40 via an OT protocol bus (which, for example, comprises two connection lines OT1 and OT2). The boiler 30 may in general be regarded as a current source supplying electrical energy to the thermostat 40.

Currently, an increasing number of thermostats are required to provide functionalities such as wireless connectivity **(e.g.,** Thread or ZigBee) and backlight display. These functionalities typically require 120 milliwatts (mW) or higher power. Providing batteries to the thermostat to support these functionalities would lead to cost issues. Moreover, battery installation and frequent replacement may cause maintenance problems.

The applicant has discovered that directly supplying power to the thermostat via the OT protocol bus can effectively circumvent the aforementioned problems. Furthermore, the applicant has studied the OT protocol and found that the OT protocol bus comprises three power modes: a low-power mode, a medium-power mode, and a high-power mode. In the low-power mode: the line current is approximately 5 to 9 milliamperes (mA), and the line voltage is typically below 8 volts (V). In the medium-power mode: the line current is approximately 17 to 23 milliamperes (mA), and the line voltage is typically below 8 volts (V). In the high-power mode: the line current is approximately 17 to 23 milliamperes (mA), and the line voltage typically ranges between 15 volts (V) and 18 volts (V). It can be seen that in the low-power mode, when the OT protocol bus is idle, the available output power is approximately 40 milliwatts (mW); in the medium-power mode, when the OT protocol bus is idle, the available output power is approximately 136 milliwatts (mW); and in the high-power mode, when the OT protocol bus is idle, the available output power is approximately 306 milliwatts (mW). Thus, only the OT high-power mode can provide sufficient electrical power to the thermostat to meet the requirements of functionalities such as wireless connectivity and backlight display.

Embodiments of the present invention disclose a technical solution for harvesting and providing relatively high electrical power (e.g., greater than 160 mW) from the high-power mode of the OT protocol bus to the thermostat. Furthermore, the power supply scheme of the embodiments of the present invention does not negatively impact normal communication over the OT protocol bus.

The above disclosure provides a detailed explanation of the technical deficiencies in the related art, the causes of such deficiencies, and the analytical process to overcome them. In fact, the recognition of the aforementioned technical deficiencies does not constitute common general knowledge in the field but represents novel discoveries made by the applicant during research. Additionally, the root cause analysis of these deficiencies and the analytical process to overcome them are also the results of the applicant's step-by-step analysis during actual research, and are not common knowledge in the field.

FIG. 2 is an exemplary structural diagram of an OT protocol-based power harvesting apparatus according to an embodiment of the present invention. The OT-based power harvesting apparatus 100 may be arranged in a thermostat as a component of the thermostat. Alternatively, the OT-based power harvesting apparatus 100 may be implemented as a discrete component independent of the thermostat.

The power harvesting apparatus 100 comprises: a linear voltage regulator 11 configured to provide, based on an OT protocol bus **(e.g.,** the OT protocol bus may comprise two connection lines, namely, the connection line OT1 and the connection line OT2) in a low-power mode, a first output voltage suitable for starting a controller 19 **(e.g.,** typically a microcontroller (MCU)) comprised in an electrical load module 18 of a thermostat; a variable voltage module 12 configured to adjust a voltage drop of the variable voltage module 12 based on a voltage control command issued by the controller 19 after startup, the voltage drop representing an instruction, to be detected by a boiler, instructing the OT protocol bus to enter a high-power mode; an energy storage module 13 coupled to the variable voltage module 12 and configured to harvest and store electrical energy from the OT protocol bus during a non-communication period in the high-power mode; and a DC-DC converter 14 coupled to the energy storage module 13 and configured to convert a voltage of the stored electrical energy in the energy storage module 13 into a second output voltage suitable for supplying power to the electrical load module 18 of the thermostat. Here, the "non-communication period" refers to a time period during which neither the thermostat initiates communication to the boiler nor the boiler initiates communication to the thermostat. In other words, during the non-communication period, the thermostat does not initiate communication to the boiler, and the boiler likewise does not initiate communication to the thermostat.

It can be seen that there is no need to provide a battery for the thermostat. The OT protocol bus in the high-power mode can directly provide electrical energy for the thermostat, thereby saving battery costs and reducing maintenance difficulty. Moreover, compared to an existing processing mechanism that utilizes a linear voltage regulator to supply power to the electrical load module, in the embodiment of the present invention, using a DC-DC converter to convert electrical energy of an energy storage module into a second output voltage suitable for supplying power to an electrical module can provide a greater output power, thereby satisfying specific power requirements of the thermostat **(e.g.,** functionalities such as wireless connectivity and backlight display).

In an embodiment, the power harvesting apparatus 100 comprises: a polarity orientation module 10 coupled between the variable voltage module 12 and the OT protocol bus and configured to perform polarity orientation on a current input from the OT protocol bus to the variable voltage module 12. Therefore, the polarity orientation module 10 can achieve the polarity orientation function of the OT protocol bus, regardless of the polarities of the connection line OT1 and the connection line OT2. In an embodiment, the polarity orientation module 10 comprises a bridge rectifier circuit. Therefore, based on the bridge rectifier circuit, polarity orientation can be easily achieved.

In an embodiment, the variable voltage module 12 comprises a voltage regulator diode and a first switch coupled in parallel with the voltage regulator diode, where the first switch is controlled by the controller 19. The voltage regulator diode, also known as a Zener diode, is a diode having a voltage regulation function that is produced based on the reverse breakdown state of a PN junction, where the current may vary over a wide range while the voltage remains substantially constant. The forward characteristic of the current-voltage characteristic curve of the voltage regulator diode is similar to that of an ordinary diode. The reverse characteristic exhibits a very large reverse resistance and extremely small reverse leakage current when the reverse voltage is below the reverse breakdown voltage. However, when the reverse voltage approaches the critical value of the reverse voltage, the reverse current increases abruptly (referred to as breakdown). At this critical breakdown point, the reverse resistance sharply drops to a very small value. Although the current varies within a large range, the voltage across the voltage regulator diode remains essentially stable near the breakdown voltage, thereby achieving the voltage regulation function of the voltage regulator diode. Therefore, based on the controlled first switch and the voltage regulator diode, a variable voltage module 12 can be conveniently implemented.

In an embodiment, the power harvesting apparatus 100 comprises: a current limiting module 15 coupled between the energy storage module 13 and the variable voltage module 12 and configured to limit current flowing into the energy storage module 13 to not exceed a predetermined current limit threshold. It can be seen that by limiting the current flowing into the energy storage module, the normal operation of the linear voltage regulator 11 and the variable voltage module 12 can be guaranteed. In an embodiment, the current limit threshold is less than or equal to 15 milliamperes.

In an embodiment, the power harvesting apparatus 100 comprises: a resistor 16 coupled between the polarity orientation module 10 and the linear voltage regulator 11; a comparator 17, where a first input terminal of the comparator 17 is coupled to an output terminal of the linear voltage regulator 11, a second input terminal of the comparator 17 is coupled to a coupling point between the resistor 16 and the polarity orientation module 10, and an output terminal of the comparator 17 is coupled to the controller 19; and the comparator 17 is configured to compare an input current at the first input terminal with an input current at the second input terminal, and output, via the output terminal of the comparator 17, a logic voltage signal determined based on a comparison result; and the controller 19 configured to, when the logic voltage signal matches a signal pattern **(e.g.,** a high-low level sequence with a predetermined format that corresponds to the response message) of a response message sent by the boiler to the thermostat, generate a state indication representing reception of the reply message. Therefore, through the detection and comparison processes of the comparator on the bus current, the controller can conveniently receive the response message sent by the boiler to the thermostat, thereby facilitating confirmation of the non-communication period.

In an embodiment, the power harvesting apparatus 100 comprises: a second switch k2 coupled between the variable voltage module 12 and the current limiting module 15; a third switch k3 coupled between the DC-DC converter 14 and the electrical load module 18; and a fourth switch k4 coupled between the linear voltage regulator 11 and the electrical load module 18, where the second switch k2, the third switch k3, and the fourth switch k4 are separately controlled by the controller 19. Therefore, through multiple controlled switches, the control methods can be diversified.

For example, the control method may comprise the following. (1) When the OT bus is in a low-power mode, the first switch is disengaged, the second switch k2 is disengaged, the third switch k3 is disengaged, and the fourth switch k4 is engaged, thereby starting the controller. (2) After the controller is started, the controller 19 controls the first switch to perform a predetermined series of actions including disengaging and engaging to affect the voltage sequence (including high levels and low levels) on the OT bus, thereby issuing an instruction to the boiler that indicates entry into a high-power mode. (3) When the OT bus is in the high-power mode and an idle state, the controller 19 controls the second switch k2 to be engaged and the third switch k3 to be disengaged, so as to charge the energy storage module 13. (3) When the thermostat communicates with the boiler (for example, the thermostat sends a command to the boiler or receives a response message from the boiler), causing the OT bus to be not idle, even if the OT bus is in the high-power mode, the controller 19 still controls the second switch k2 to be disengaged, thereby stopping charging the energy storage module 13 to avoid interfering with data communication on the OT bus. (4) When the charging time of the energy storage module 13 reaches a predetermined time threshold or the energy storage voltage reaches a predetermined voltage threshold, the controller 19 controls the second switch k2 to be disengaged, the third switch k3 to be engaged, and the fourth switch k4 to be disengaged, so that the energy storage module 13 provides electrical energy to the thermostat via the DC-DC converter 14.

In an embodiment, the electrical load module 18 comprises at least one of the following: the controller 19; a wireless connection module 20; and a backlight apparatus 21 for providing backlight. For example, the wireless connection module 20 may be implemented as a Thread module, a ZigBee module, an infrared module, a 4G module, a 5G module, an NFC module, and the like. The backlight apparatus 21 may be implemented as a liquid crystal display (LCD), an LED display, a Micro-LED display or a Mini LED display, etc.

The above exemplarily describes typical examples of the wireless connection module and the backlight apparatus. Those skilled in the art will recognize that such descriptions are merely exemplary and are not intended to limit the scope of protection of the present invention.

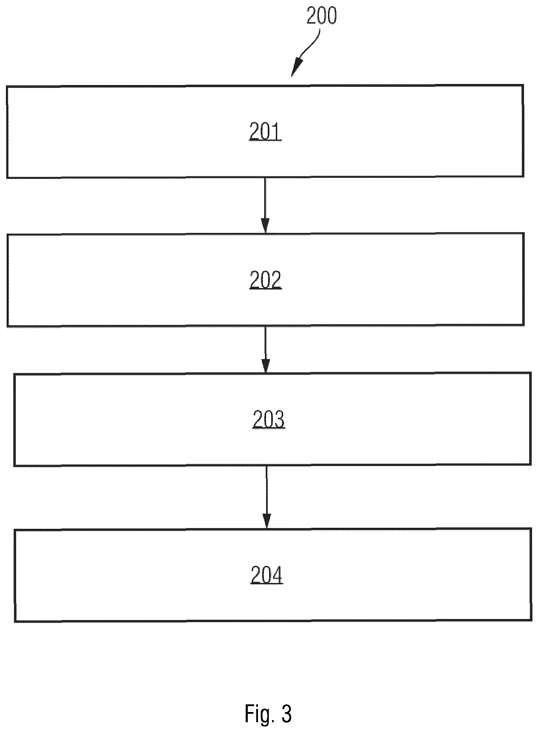

FIG. 3 is a flowchart of an OT protocol-based thermostat power supply method according to an embodiment of the present invention. As shown in FIG. 3, the OT-based thermostat power supply method 200 comprises the following steps.

Step 201: providing, based on an OT protocol bus in a low-power mode, a first output voltage suitable for starting a controller comprised in an electrical load module of a thermostat.

Step 202: issuing, based on a voltage control command issued by the controller after startup, an instruction instructing the OT protocol bus to enter a high-power mode.

Step 203: after the OT protocol bus enters the high-power mode, harvesting and storing electrical energy from the OT protocol bus during a non-communication period in the high-power mode.

Step 204: converting a voltage of the stored electrical energy into a second output voltage suitable for supplying power to the electrical load module of the thermostat.

In an embodiment, the method comprises: after the OT protocol bus enters the high-power mode, determining the non-communication period in the high-power mode when the controller is determined to be not initiating communication with the boiler and the controller determines that a logic voltage signal does not match a signal pattern of a response message sent by the boiler to the thermostat, where the logic voltage signal is determined based on a current of the OT protocol bus. Specifically, after the OT protocol bus enters the high-power mode, the controller can know whether it is initiating communication with the boiler. Additionally, based on matching the logic voltage signal provided by the comparator with the signal pattern of the response message sent from the boiler to the thermostat, the controller can determine whether the boiler is sending a response message to the thermostat (where: a match indicates that the boiler is sending the response message; and a mismatch indicates that the boiler is not sending the response message). Therefore, the controller can accurately and conveniently determine the non-communication period during which no data communication occurs between the thermostat and the boiler.

In an embodiment, the harvesting and storing electrical energy from the OpenTherm protocol bus during a non-communication period in the high-power mode in step 203 comprises: limiting an energy storage current to not exceed a predetermined current limit threshold in a process of harvesting and storing electrical energy from the OpenTherm protocol bus during the non-communication period in the high-power mode.

In an embodiment, the converting a voltage of the stored electrical energy into a second output voltage suitable for supplying power to the electrical load module of the thermostat in step 204 comprises:
(1) converting the voltage of the stored electrical energy to the second output voltage suitable for supplying power to the electrical load module of the thermostat when a duration for harvesting and storing electrical energy from the OpenTherm protocol bus during the non-communication period in the high-power mode reaches a predetermined time threshold; or
(2) converting the voltage of the stored electrical energy to the second output voltage suitable for supplying power to the electrical load module of the thermostat when the voltage of the stored electrical energy reaches a predetermined voltage threshold.

It can be seen that an appropriate timing for supplying power to the electrical load module can be determined based on multiple methods.

The typical circuit structure of the OT protocol-based power harvesting apparatus 100 as shown in FIG. 2 is described below.

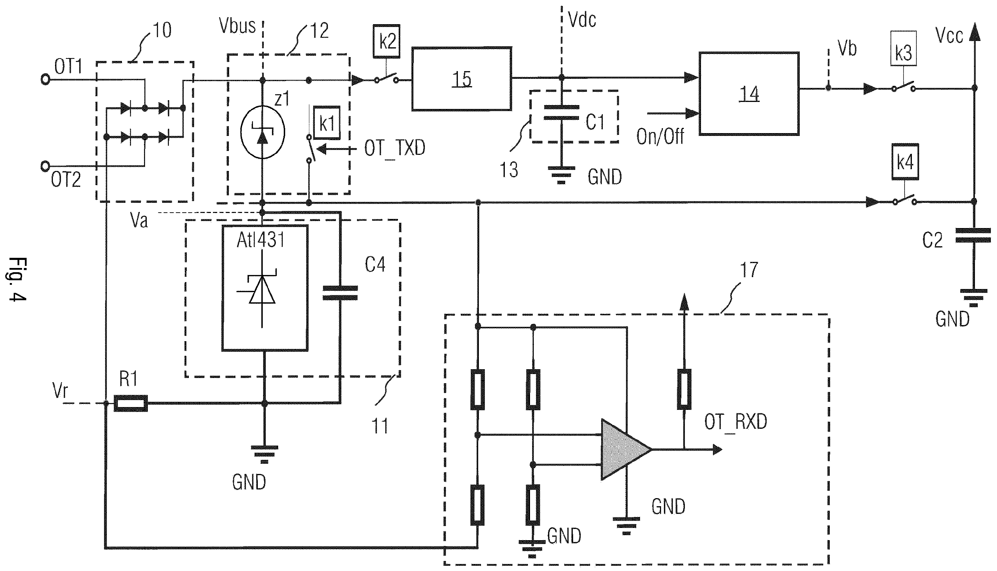

FIG. 4 is an exemplary circuit structure diagram of an OT protocol-based power harvesting apparatus according to an embodiment of the present invention.

In FIG. 4, the linear voltage regulator 11 comprises a controllable precision voltage regulator ATL431, with the controllable precision voltage regulator ATL431 grounded (GND). The polarity orientation module 10 comprises a bridge rectifier circuit composed of four diodes. The variable voltage module 12 comprises a voltage regulator diode z1 and a first switch k1 coupled in parallel with the voltage regulator diode z1. The precision voltage regulator TL431 can typically only provide electrical energy of 50 mW (3.3V/15mA). In FIG. 4, the first switch k1, the second switch k2, the third switch k3, and the fourth switch k4 are all switches controlled by the controller (not shown in FIG. 4, e.g., an MCU) of the thermostat. The first switch k1, the second switch k2, and the third switch k3 are disengaged by default, and the fourth switch k4 is engaged by default.

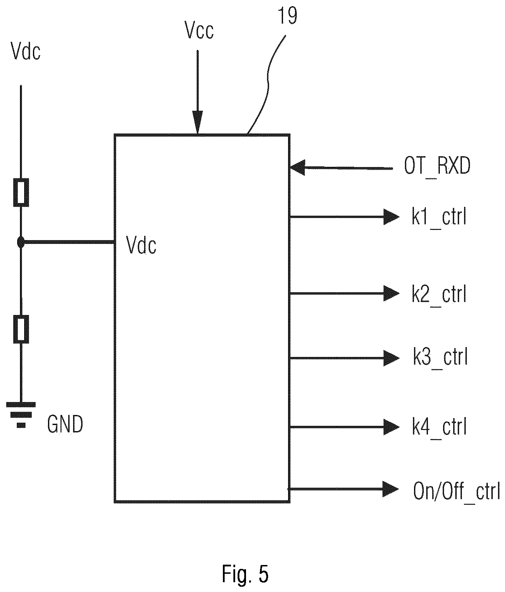

FIG. 5 is an exemplary schematic diagram of a controller in a thermostat according to an embodiment of the present invention. Based on FIG. 5, it can be seen that the input signal of the controller 19 comprises a logic voltage signal OT_RXD provided by the comparator. The output signal of the controller 19 comprises: (1) a k1_ctrl control command for controlling the first switch k1 to be engaged or disengaged; (2) a k2_ctrl control command for controlling the second switch k2 to be engaged or disengaged; (3) a k3_ctrl control command for controlling the third switch k3 to be engaged or disengaged; (4) a k4_ctrl control command for controlling the fourth switch k4 to be engaged or disengaged; and (5) an on/off_ctrl control command for enabling or disabling the DC-DC converter 14.

First, based on the requirements of the OT specification, it is necessary to start from the low-power mode. After connecting to the OT bus (which, for example, comprises two connection lines OT1 and OT2), the ATL431 will generate a 3.3V DC voltage Va. At this point, the first switch k1 is in the disengaged state by default, and the second switch k2 is in the disengaged state by default, so that the current on the OT protocol bus will completely flow through the voltage regulator diode z1 **(e.g.,** a 12V voltage regulator diode). The fourth switch k4 is in the engaged state by default, short-circuiting Va to Vcc. Considering the current passing through the ATL431 and the comparator 17, Va can provide a current of 4.8 mA. The controller can be started from Vcc, where C4 connected in parallel with the ATL431 is an energy storage capacitor used to meet the peak current demand during startup of the controller.

Then, when the controller is started, the controller will communicate with the boiler to switch the OT bus to the high-power mode. The OT bus in the high-power mode can provide a line current of approximately 15 mA. At this point: the controller outputs the k1_ctrl control command to control the first switch k1 to be disengaged or engaged, thereby generating a voltage sequence (including high voltages or low voltages) representing an instruction on the OT bus accordingly. The instruction is used to instruct the OT protocol bus to enter the high-power mode. After receiving the instruction based on detection of the voltage sequence, the boiler enters the high-power mode of the OT protocol bus. R1 is a current sensing resistor (equivalent to resistor 16 in FIG. 2). The comparator 17 converts the current signal on the OT bus into a logic voltage signal OT_RXD. Based on the logic voltage signal OT_RXD, the controller can confirm whether the boiler is sending a response message to the thermostat.

Next, the controller begins to harvest more electrical energy. During the idle state of the OT bus (i.e., when no data is being sent between the thermostat and the boiler), the controller outputs a k2_ctrl control signal to engage the second switch k2. The bus voltage Vbus will charge the capacitor C1 through the current limiting module 15. The current limiting module 15 limits the current to less than 15 mA. Consequently, the bus voltage will remain stable (approximately 15V to 18V). After the capacitor C1 is fully charged, the controller outputs an On/Off_control signal to enable the DC-DC converter 14 to generate the voltage Vb (approximately +3.3V). The controller then outputs a k4_ctrl control signal to disengage the fourth switch k4 and outputs a k3_ctrl control signal to engage the third switch k3. The voltage Vb generated by the DC-DC converter 14 can provide electrical energy to various electrical load modules in the thermostat. Vcc is switched from Va to Vb. The capacitor C2 provides electrical energy to maintain Vcc to be stable during the switching process.

Each communication process of the OT bus is initiated by the thermostat. Before the thermostat begins to send communication data, the controller outputs the k2_ctrl control signal to disengage the second switch k2, thereby stopping charging the capacitor C1, which can avoid affecting the rising and falling edges of the voltage waveform on the OT bus. The capacitance value of the capacitor C1 may be large enough to continuously provide electrical energy to the DC-DC converter 14 during data transmission of the thermostat.

After the communication transmission between the thermostat and the boiler is completed, the controller outputs the k2_ctrl control signal to engage the second switch k2, so that the OT protocol bus continues to charge the capacitor C1 and waits for feedback from the boiler (sending a response message). When the controller detects a voltage change of OT_RXD, it indicates that the boiler has started sending a response message. At this point, the controller will output the k2_ctrl control signal again to disengage the second switch k2 to avoid affecting the data transmission of the boiler. When the thermostat completes receiving a data frame from the boiler, the controller will output a k2_ctrl control signal to engage the second switch k2, enabling the OT protocol bus to charge the capacitor C1 again. The capacitor C1 provides electrical energy to the DC-DC converter 14 during the period in which the thermostat receives data.

Based on the above description, it can be seen that for a conventional circuit design, if a linear power supply is used, assuming that the output voltage is 3.3V, then the maximum output power in the OT high-power mode is: 3.3 volts (V)*15 milliamperes (mA), that is, 49.5 milliwatts, demonstrating that the high voltage on the OT bus is not fully utilized. For the embodiment of the present invention, the maximum input power in the OT high-power mode is: 15 volts (V)*15 (mA) = 225 milliwatts. Assuming an efficiency of 85% for the DC-DC converter, the maximum output power is: 225*0.85 = 191.25 milliwatts. It can be seen that compared with the conventional circuit design, the output power of the embodiments of the present invention is significantly improved.

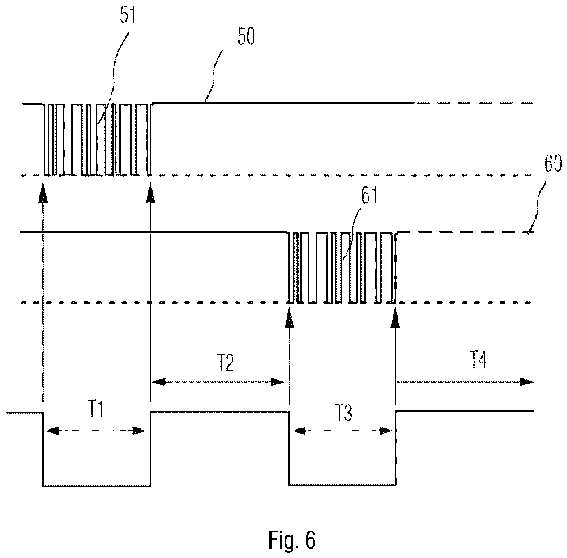

FIG. 6 is a schematic diagram illustrating data transmission and switch states according to an embodiment of the present invention. Based on the data transmission waveform 50 of the thermostat, in a first data transmission period 51, the thermostat sends data to the boiler. During a time period T1 corresponding to the first data transmission period 51, the second switch k2 is disengaged, so that the OT protocol bus stops charging the capacitor C1. Based on the data transmission waveform 60 of the boiler, in the second data transmission period 61, the boiler sends data to the thermostat. Therefore, during a time period T3 corresponding to the second data transmission period 61, the second switch k2 is disengaged, so that the OT protocol bus stops charging the capacitor C1. During a time period T2 between the first data transmission period 51 and the second data transmission period 61, the second switch k2 is engaged, so that the OT protocol bus charges the capacitor C1. During a time period T4 following the second data transmission period 61, the second switch k2 is engaged, so that the OT protocol bus charges the capacitor C1.

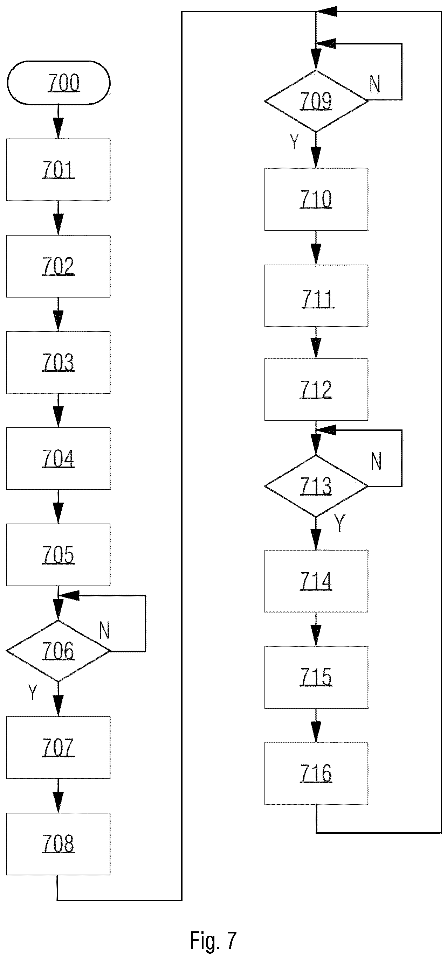

Based on the description of FIGS. 4 to 6, FIG. 7 is an exemplary flowchart of an OT protocol-based thermostat power supply method according to an embodiment of the present invention. As shown in FIG. 7, the method comprises the following steps.

Step 700: starting this process.

Step 701: connecting the thermostat to the OT protocol bus.

Step 702: connecting Vcc to Va.

Step 703: starting the controller of the thermostat.

Step 704: switching the OT bus mode to a high-power mode.

Step 705: the controller engages the second switch k2.

Step 706: determining whether the capacitor C1 has completed charging, and if yes (corresponding to the **"Y"** branch), executing step 707 and its subsequent steps; otherwise (corresponding to the **"N"** branch), waiting for a predetermined time and then returning to execute step 706.

Step 707: enabling the DC-DC converter so that the DC-DC converter converts the voltage of the stored electrical energy in the capacitor C1 into an output voltage Vb suitable for supplying power to the thermostat.

Step 708: switching Vcc to connect to Vb.

Step 709: determining whether data needs to be transmitted, and if yes (corresponding to the "Y" branch), executing step 710 and its subsequent steps; otherwise (corresponding to the "N" branch), waiting for a predetermined time and then returning to execute step 709.

Step 710: the controller controls the second switch k2 to be disengaged.

Step 711: transmitting the data.

Step 712: the controller controls the second switch k2 to be engaged.

Step 713: determining whether the bus current switches from high to low, and if yes (corresponding to the "Y" branch), which indicates that the boiler starts to transmit the data, executing step 714 and its subsequent steps; otherwise (corresponding to the "N" branch), waiting for a predetermined time and then returning to execute step 713.

Step 714: the controller controls the second switch k2 to be disengaged.

Step 715: receiving the data from the boiler.

Step 716: the controller controls the second switch k2 to be engaged, and returns to execute step 709.

The embodiments of the present invention further propose an OT protocol-based thermostat. The thermostat comprises: a controller; a wireless connection module; a backlight apparatus; and a power harvesting apparatus 100 as shown in FIG. 1, which is configured to supply power to the controller, the wireless connection module, and the backlight apparatus. The embodiments of the present invention further propose an OT protocol-based system. With reference to FIG. 1, the system comprises: a boiler 30; and a thermostat 40, which comprises a power harvesting apparatus 100 as shown in FIG. 1.

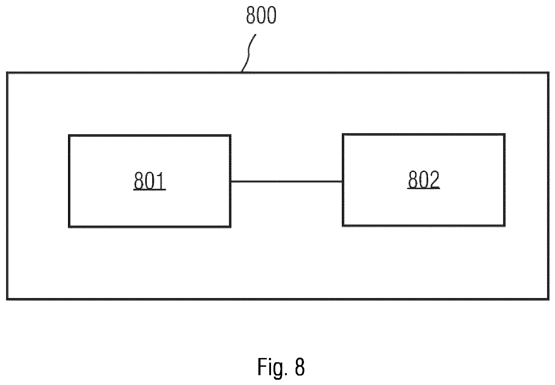

The embodiments of the present invention further propose an electronic device with a processor-memory architecture. FIG. 8 is an exemplary structural diagram of an electronic device according to an embodiment of the present invention. As shown in FIG. 8, the electronic device 800 comprises a processor 801, a memory 802, and a computer program stored on the memory 802 and executable on the processor 801, where the computer program, when executed by the processor 801, implements the OT protocol-based thermostat power supply method as described in any of the above. The memory 802 can be specifically implemented as various storage media such as an electrically erasable programmable read-only memory (EEPROM), flash memory, programmable read-only memory (PROM), etc. The processor 801 can be implemented as including one or more central processing units or one or more field-programmable gate arrays (FPGAs), where the FPGA integrates one or more central processing unit cores. Specifically, the central processing unit or central processing unit core can be implemented as a CPU, an MCU, a DSP, etc.

It should be noted that not all steps and modules in the aforementioned processes and structural diagrams are mandatory. Certain steps or modules may be omitted according to actual needs. The execution order of steps is not fixed and can be adjusted as required. The division of modules is merely functional partitioning for ease of description. In practical implementation, one module may be divided into multiple modules, and the functions of multiple modules may also be implemented by a single module. These modules may reside in the same device or different devices.

Hardware modules in various embodiments may be implemented mechanically or electronically. For example, a hardware module may comprise permanently designed circuits or logic devices (e.g., specialized processors such as FPGAs or ASICs) to perform specific operations. A hardware module may also comprise programmable logic devices or circuits (e.g., general-purpose processors or other programmable processors) temporarily configured by software to execute specific operations. The choice between mechanical implementation, dedicated permanent circuits, or temporarily configured circuits (e.g., software-configured) for hardware modules may depend on cost and time considerations.

The present invention further provides a machine-readable storage medium storing instructions for causing a machine to execute the methods described in the present application. Specifically, a system or apparatus equipped with a storage medium may be provided, where the storage medium stores software program code configured to implement the functions of any embodiment in the aforementioned example embodiments, and causes a computer (e.g., CPU, MCU, or MPU) of the system or apparatus to read and execute the program code stored in the storage medium. Additionally, part or all of the actual operations may be completed by an operating system running on the computer based on instructions from the program codes. Program codes read from the storage medium may also be written into a memory set in an expansion board inserted into the computer or into a memory set in an expansion unit connected to the computer. Subsequently, part or all of the actual operations may be executed by a control unit installed on the expansion board or expansion unit based on instructions from the program codes, thereby achieving the functions of any embodiment described above. Storage medium embodiments for providing program codes comprise floppy disks, hard disks, magneto-optical disks, optical disks (e.g., CD-ROM, CD-R, CD-RW, DVD-ROM, DVD-RAM, DVD-RW, DVD+RW), magnetic tapes, nonvolatile memory cards, and ROM. Alternatively, program codes may be downloaded from a server computer or cloud via a communication network.

The above descriptions represent only preferred embodiments of the present invention and are not intended to limit the scope of protection. Any modifications, equivalent substitutions, or improvements made within the spirit and principles of the present invention shall fall within the scope of protection of the present invention.

## Claims

1. An OpenTherm protocol-based power harvesting apparatus (100), comprising:
a linear voltage regulator (11) configured to provide, based on an OpenTherm protocol bus in a low-power mode, a first output voltage suitable for starting a controller (19) comprised in an electrical load module (18) of a thermostat;
a variable voltage module (12) configured to adjust a voltage drop of the variable voltage module (12) based on a voltage control command issued by the controller (19) after startup, the voltage drop representing an instruction, to be detected by a boiler, instructing the OpenTherm protocol bus to enter a high-power mode;
an energy storage module (13) coupled to the variable voltage module (12) and configured to harvest and store electrical energy from the OpenTherm protocol bus during a non-communication period in the high-power mode; and
a DC-DC converter (14) coupled to the energy storage module (13) and configured to convert a voltage of the stored electrical energy in the energy storage module (13) into a second output voltage suitable for supplying power to the electrical load module (18) of the thermostat.

2. The apparatus (100) according to claim 1, comprising:
a polarity orientation module (10) coupled between the variable voltage module (12) and the OpenTherm protocol bus and configured to perform polarity orientation on a current input from the OpenTherm protocol bus to the variable voltage module (12).

3. The apparatus (100) according to claim 2, wherein the polarity orientation module (10) comprises a bridge rectifier circuit.

4. The apparatus (100) according to claim 1, wherein the variable voltage module (12) comprises a voltage regulator diode (z1) and a first switch (k1) coupled in parallel with the voltage regulator diode (z1), wherein the first switch (k1) is controlled by the controller (19).

5. The apparatus (100) according to claim 1, comprising:
a current limiting module (15) coupled between the energy storage module (13) and the variable voltage module (12) and configured to limit current flowing into the energy storage module (13) to not exceed a predetermined current limit threshold.

6. The apparatus (100) according to claim 5, wherein the current limit threshold is less than or equal to 15 milliamperes.

7. The apparatus (100) according to claim 2, comprising:
a resistor (16) coupled between the polarity orientation module (10) and the linear voltage regulator (11); and
a comparator (17), wherein
a first input terminal of the comparator (17) is coupled to an output terminal of the linear voltage regulator (11), a second input terminal of the comparator (17) is coupled to a coupling point between the resistor (16) and the polarity orientation module (10), and an output terminal of the comparator (17) is coupled to the controller (19); and
the comparator (17) is configured to compare an input current at the first input terminal with an input current at the second input terminal, and output, via the output terminal of the comparator (17), a logic voltage signal determined based on a comparison result; and
the controller (19) configured to, when the logic voltage signal matches a signal pattern of a response message sent by the boiler to the thermostat, generate a state indication representing reception of the response message.

8. The apparatus (100) according to claim 5, comprising:
a second switch (k2) coupled between the variable voltage module (12) and the current limiting module (15);
a third switch (k3) coupled between the DC-DC converter (14) and the electrical load module (18); and
a fourth switch (k4) coupled between the linear voltage regulator (11) and the electrical load module (18),
wherein the second switch (k2), the third switch (k3), and the fourth switch (k4) are separately controlled by the controller (19).

9. The apparatus (100) according to any one of claims 1 to 8, wherein the electrical load module (18) comprises at least one of:
the controller (19); a wireless connection module (20); and a backlight apparatus (21).

10. An OpenTherm protocol-based thermostat, comprising:
a controller;
a wireless connection module;
a backlight apparatus; and
an OpenTherm protocol-based power harvesting apparatus (100) according to any one of claims 1 to 9, which is configured to supply power to the controller, the wireless connection module,
and the backlight apparatus.

11. An OpenTherm protocol-based system, comprising:
a boiler (30); and
a thermostat (40), the thermostat (40) comprising an OpenTherm protocol-based power harvesting apparatus (100) according to any one of claims 1 to 9.

12. An OpenTherm protocol-based thermostat power supply method (200), comprising:
providing (201), based on an OpenTherm protocol bus in a low-power mode, a first output voltage suitable for starting a controller comprised in an electrical load module of a thermostat;
issuing (202), based on a voltage control command issued by the controller after startup, an instruction instructing the OpenTherm protocol bus to enter a high-power mode;
after the OpenTherm protocol bus enters the high-power mode, harvesting and storing (203) electrical energy from the OpenTherm protocol bus during a non-communication period in the high-power mode; and
converting (204) a voltage of the stored electrical energy into a second output voltage suitable for supplying power to the electrical load module of the thermostat.

13. The method (200) according to claim 12, comprising:
after the OpenTherm protocol bus enters the high-power mode, determining the non-communication period in the high-power mode when the controller is determined to be not initiating communication with the boiler and the controller determines that a logic voltage signal does not match a signal pattern of a response message sent by the boiler to the thermostat, wherein the logic voltage signal is determined based on a current of the OpenTherm protocol bus.

14. The method (200) according to claim 12, wherein the harvesting and storing (203) electrical energy during a non-communication period in the high-power mode comprises:
limiting an energy storage current to not exceed a predetermined current limit threshold in a process of harvesting and storing electrical energy from the OpenTherm protocol bus during the non-communication period in the high-power mode.

15. The method according to claim 12, wherein the converting (204) a voltage of the stored electrical energy into a second output voltage suitable for supplying power to the electrical load module of the thermostat comprises:
converting the voltage of the stored electrical energy to the second output voltage suitable for supplying power to the electrical load module of the thermostat when a duration for harvesting and storing electrical energy from the OpenTherm protocol bus during the non-communication period in the high-power mode reaches a predetermined time threshold; or
converting the voltage of the stored electrical energy to the second output voltage suitable for supplying power to the electrical load module of the thermostat when the voltage of the stored electrical energy reaches a predetermined voltage threshold.

16. An electronic device (800), comprising:
a processor (801); and
a memory (802) configured to store executable instructions of the processor (801), wherein
the processor (801) is configured to read the executable instructions from the memory (802) and execute the executable instructions to implement the OpenTherm protocol-based thermostat power supply method according to any one of claims 12 to 15.

17. A computer-readable storage medium having computer instructions stored thereon, wherein the computer instructions, when executed by a processor, implement the OpenTherm protocol-based thermostat power supply method (200) according to any one of claims 12 to 15.

18. A computer program product, comprising a computer program, wherein the computer program, when executed by a processor, implements the OpenTherm protocol-based thermostat power supply method (200) according to any one of claims 12 to 15.
